# EUROPEAN PATENT APPLICATION

(11) **EP 1 376 670 A1**
(43) Date of publication of application: **02.01.2004**
(21) Application number: 02708713.9
(22) Date of filing: 28.03.2002
(51) Int. Cl.: H01L 21/31, H01L 21/3065, H05H 1/46

(54) **PLASMA PROCESSING DEVICE**

(30) Priority: 28.03.2001 JP 2001094275
(71) Applicant: Tokyo Electron Limited, Tokyo 107-8481 (JP); Ohmi, Tadahiro, Sendai-shi, Miyagi-ken 980-0813 (JP)
(72) Inventor: OHMI, Tadahiro, Sendai-Shi, Miyagi 980-0813 (JP); HIRAYAMA, Masaki School of Engineering Tohoku Uni., Sendai-shi, Miyagi 980-8579 (JP); SUGAWA, S., School of Engineering Tohoku Univers., Sendai-shi, Miyagi 980-8579 (JP); GOTO, Tetsuya, School of Engineering Tohoku Uni., Sendai-shi, Miyagi 980-8579 (JP)
(74) Representative: Liesegang, Eva
(86) International application number: PCT/JP2002/003111
(87) International publication number: WO 2002/080252

(57) **Abstract**

In a microwave plasma processing apparatus, a shower plate or plasma transmission window facing a substrate to be processed is formed to have a concaved surface at a side facing the substrate to be processes for compensating for a decrease of plasma density in the peripheral region of the substrate to be processed. As a result, stable and uniform plasma is maintained in the vicinity of the surface of the substrate to be processed even in the case a low pressure plasma process such as etching is conducted. Further, such a construction facilitates plasma ignition.

## Description

### TECHNICAL FIELD

The present invention relates to plasma processing apparatuses and more particularly to a microwave plasma processing apparatus.

### BACKGROUND ART

The art of plasma process and plasma processing apparatuses is the technology indispensable for the fabrication of recent ultrafine semiconductor devices called deep submicron devices or deep sub-quarter micron devices having a gate length of 0.1µm or less or for the fabrication of high-resolution flat display devices including a liquid crystal display device.

Various plasma excitation methods have been employed in the microwave plasma-processing apparatus for use in the fabrication of semiconductor devices or liquid crystal display devices. Particularly, a plasma processing apparatus of parallel-plate type that uses high-frequency plasma excitation or a plasma processing apparatus of induction-coupled type has been used commonly. However, these conventional plasma processing apparatuses have a drawback of nonuniform plasma formation in that the region of high electron density is limited. As a result, it is difficult to conduct a uniform processing over the entire surface of the substrate. This problem becomes particularly serious when processing a large-diameter substrate. Further, such a conventional plasma processing apparatus has inherent problems, associated with its high electron temperature, in that damages are caused in the semiconductor devices formed.on the substrate. Further, severe metal contamination may be caused as a result of sputtering of the chamber wall. Thus, it is becoming difficult with conventional plasma processing apparatuses to satisfy the stringent demand of further miniaturization and further improvement of productivity of semiconductor devices or flat display devices.

Meanwhile, there has been a proposal of a microwave plasma processing apparatus that uses high-density plasma excited, not by D.C. magnetic field, but by a microwave electric field. For example, there is a proposal of a plasma processing apparatus that excites plasma by emitting a microwave into a processing vessel from a planar antenna (radial line slot antenna) having a number of slots arranged so as to produce a uniform microwave. In this plasma processing apparatus, the microwave electric field induces plasma by causing ionization in the gas in the vacuum vessel. Reference should be made to Japanese Laid-Open Patent Application 9-63793. By using the microwave plasma excited according to such a process, it becomes possible to realize a high-plasma density over a wide area right underneath the antenna, and uniform plasma processing becomes possible with short time period. Further, the microwave plasma thus excited has an advantageous feature of low electron temperature as a result of excitation of the plasma by using a microwave, and it becomes possible to avoid the problem of damages or metal contamination caused in the substrate. Further, it becomes possible to excite uniform plasma over a substrate of large area, and thus, the plasma processing apparatus can easily handle the fabrication of semiconductor devices on a large-diameter semiconductor wafer or fabrication of large flat panel display devices.

### BACKGROUND ART

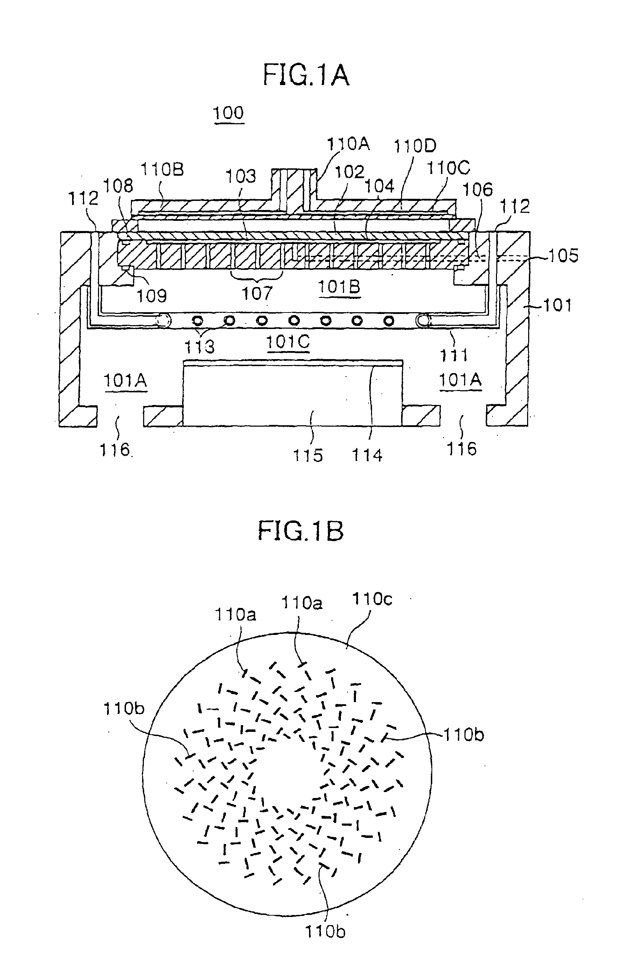

FIGS.1A and 1B show the construction of such a microwave plasma processing apparatus 100 that uses such a radial line slot antenna, wherein FIG.1A represents the microwave plasma processing apparatus in a cross-sectional view, while FIG.1B shows the construction of the radial line slot antenna.

Referring to FIG.1A, the microwave plasma processing apparatus 100 includes a processing chamber 101 evacuated at a plurality of evacuation ports 116, and there is provided a stage 115 inside the processing chamber 101 for supporting a substrate 114 to be processed, In order to achieve uniform evacuation of the processing chamber 101, there is provided a ring-shaped space 101A around the stage 115, and the processing chamber 101 is evacuated uniformly via the space 101A and further via the evacuation ports 116 by arranging the evacuation ports 116 communicating with the space 101A with an equidistance, and hence in axial symmetry with respect to the substrate.

On the processing chamber 101, there is provided a plate-like shower plate 103 formed of a dielectric of low dielectric loss as a part of the wall of the processing chamber 101 at a location corresponding to the substrate 114 held on the stage 115, wherein the shower plate 103 is provided via a seal ring 109 and includes a number of apertures 107. Further, a cover plate 102 also of a dielectric of low dielectric loss is provided at the outer side of the shower plate 103 via another seal ring 108.

The shower plate 103 is provided with a gas passage 104 at a top surface thereof, and each of the apertures 107 are provided so as to communicate with the gas passage 104. Further, there is provided a gas supply passage 108 in the interior of the shower plate 103 in communication with a gas supply port 105 provided at an wall of the processing vessel 101. Thus, the plasma-excitation gas such as Ar or Kr supplied to the gas supply port 105 is forwarded to the apertures 107 via the supply passage 108 and further via the passage 104 and is released to the process space 101B right underneath the shower plate 103 inside the processing vessel 101 from the foregoing apertures 107 with substantially uniform concentration.

On the processing vessel 101, there is further provided a radial line slot antenna 110 having a radiation surface shown in FIG.1B at the outer side of the cover plate 102 with a separation of 4 - 5mm from the cover plate 102. The radial line slot antenna 110 is connected to an external microwave source (not illustrated) via a coaxial waveguide 110A and causes excitation of the plasma gas released into the process space 101B by the microwave from the microwave source. It should be noted that gap between the cover plate 102 and the radiation surface of the radial line slot antenna 110 is filled with the air.

The radial line slot antenna 110 is formed of a flat, disk-shaped antenna body 110A connected to an outer waveguide tube of the coaxial waveguide 110A and a radiation plate 110C provided at the opening of the antenna body 110B, wherein the radiation plate 110C is formed with a number of slots 110a and 110b with respective orientations crossing perpendicularly with each other as shown in FIG.1B. Further, a retardation plate 110D of a dielectric having a constant thickness is interposed between the antenna body 110B and the radiation plate 110C.

In the radial line slot antenna 110 having such a construction, the microwave fed thereto from the coaxial waveguide 110 propagates along a path between the disk-shaped antenna body 110B and the radiation plate 110C in the radial direction, wherein the microwave thus propagating undergoes compression of wavelength as a result of the function of the retardation plate 110D. Thus, by forming the slots 110a and 110b concentrically in correspondence to the wavelength of the microwave thus propagating in the radial direction, and by forming the slots 110a and 110b so as to form a perpendicular angle with each other, it becomes possible to emit a plane wave having a circular polarization in the direction substantially perpendicular to the radiation plate 110C.

By using such a radial line slot antenna 110, there is formed uniform high-density plasma in the process space 101B right underneath the shower plate 103. The high-density plasma thus formed has a feature of low electron temperature and the occurrence of damages in the substrate 114 to be processed is avoided. Further, there occurs no metal contamination caused by sputtering of the chamber wall of the processing vessel 101.

In the plasma processing apparatus 100 of FIG.1, there further provided a conductive structure 111 between the shower plate and the substrate 114, wherein the conductive structure is formed with a number of nozzles 113 supplied with a process gas from an external process gas source (not illustrated) via a process gas passage 112 formed inside the processing vessel 101, wherein each of the nozzles 113 releases the process gas thus supplied to a space 101C formed between the conductive structure 111 and the substrate 114 to be processed. In the conductive structure 113, it should be noted that there are formed openings between adjacent nozzles 113 and 113 with a size such that the plasma formed in the space 101B causes diffusion from the space 101B to the space 101C by passing through the openings.

Thus, in the case the process gas is released into the space 101C from the conductive structure 111 via the foregoing nozzle 113, the process gas undergoes excitation by the high-density plasma formed in the space 101B and a uniform plasma processing is achieved on the substrate 114 efficiently at high speed, without damaging the substrate or device structures formed on the substrate, and without contaminating the substrate. Further, it should be noted that the microwave thus emitted from the radial line slot antenna is blocked by the conductive structure 111 and there occurs no damaging in the substrate 114 by such a microwave.

In the plasma processing apparatus 100 of FIGS.1A and 1B, it should be noted that the separation between the shower plate 103 and the substrate 114 is set small, and because of this, there is formed a continuous and stable plasma flow in the space 101B and in the space 101C in the radial direction of the shower plate 103. As a result, a very uniform plasma processing becomes possible even in the case the substrate 114 is a large-diameter substrate. On the other hand, in the case the pressure inside the processing vessel 101 is reduced, there appears a tendency that the plasma density decreases at the peripheral part of the shower plate 103. In the example in which the pressure inside the processing vessel 101 has been reduced to 300 mTorr or less in an Ar ambient, there occurs a large drop of plasma density at the peripheral part of the shower plate 103. It is believed that such a drop of plasma density is caused as a result of facilitated diffusion of dissociated electrons, which takes place in the processing vessel 101 in the case the pressure therein is reduced. As a result of such facilitated diffusion of the electrons, it is believed that the electrons undergo annihilation at the inner surface of the processing vessel 101. Because the cutoff density of plasma is 7.5 x 10¹⁰cm⁻³, plasma is no longer maintained if the plasma density has been decreased below such a cutoff density. It should be noted thereby that such a drop of plasma density at the peripheral part of the shower plate 103 not only invites degradation of the processing speed but also invites the situation in which the microwave reaches directly to the substrate 114. When this occurs, there may be caused the problem of damaging in the substrate 114.

### DISCLOSURE OF THE INVENTION

Accordingly, it is a general object of the present invention to provide a novel and useful plasma processing apparatus wherein the foregoing problems are eliminated.

Another and more specific object of the present invention is to provide a plasma processing apparatus capable of conducting uniform processing over the entire surface of the substrate to be processed even in the case of using a low process pressure.

Another object of the present invention is to provide a plasma processing apparatus, comprising:
a processing vessel defined by an wall and provided with a stage for holding a substrate to be processed;
a microwave transmission window provided on said processing vessel so as to face said substrate to be processed on said stage, said microwave transmission window being provided as a part of said wall of said processing vessel;
a plasma gas supplying part supplying a plasma gas into said processing vessel; and
a microwave antenna provided on said processing vessel in correspondence to said microwave,
said microwave transmission window having a concaved inner surface at a side facing said substrate to be processed, such that a separation between said inner surface and a plane coincident to a surface of said substrate to be processed decreases in a radially outward direction of said microwave transmission window.

According to the present invention, the gap between the bottom surface of the shower plate and the surface of the substrate to be processed, in which the high-density plasma is formed, is decreased at the peripheral part of the substrate by forming the concaved surface on the shower plate at the side facing the substrate to be processed. As a result, the drop of plasma density at the peripheral part of the shower plate is compensated for, and stable and uniform plasma is maintained in the vicinity of the substrate surface even in the case a low pressure plasma process such as an etching process is conducted. Further, such a construction facilitates ignition of the plasma. Further, it should be noted that such a stabilization of the plasma by using a concaved surface is applicable not only to the construction in which a process gas supplying part is provided between the substrate and the plasma gas supplying part but also to the case in which such a process gas supplying construction is omitted.

With regard to the shower plate having such a concaved surface, it is possible to use a dense ceramic material formed with the plasma gas passage and the apertures communicating therewith. Alternatively, it is possible to use a porous ceramic material in place of the dense ceramic material. While such a shower plate is provided in intimate contact with the dense cover plate forming a part of the wall of the processing vessel and constituting the plasma transmission window, it is also possible in the present invention to provide such a concaved surface to the microwave transmission window itself. In such a case, the plasma gas is introduced into the processing chamber via a tube, or the like, without using a shower plate.

In the shower plate or microwave transmission window of the present invention, it is advantageous to form the outer surface opposing to the foregoing concaved inner surface in a flat plane for facilitating cooling of the shower plate via the antenna by way of causing intimate contact between the outer surface and the microwave antenna.

### BRIEF EXPLANATION OF THE DRAWINGS

FIGS.1A and 1B are diagrams showing the construction of a conventional microwave plasma processing apparatus that uses a radial line slot antenna;
FIGS.2A and 2B are diagrams showing the construction of a plasma processing apparatus according to a first embodiment of the present invention;
FIG.3 is a diagram showing a process gas supplying structure used in the plasma processing apparatus of FIGS. 2A and 2B;
FIG.4 is a diagram showing various modifications of the plasma processing apparatus of FIGS.2A and 2B;
FIG.5 is a diagram showing the construction of a plasma processing apparatus according to a second embodiment of the present invention;
FIG.6 is a diagram showing the construction of a plasma processing apparatus according to a third embodiment of the present invention;
FIG.7 is a diagram showing the construction of a plasma processing apparatus according to a fourth embodiment of the present invention;
FIG.8 is a diagram showing the construction of a plasma processing apparatus according to a fifth embodiment of the present invention;
FIG.9 is a diagram showing the construction of a plasma processing apparatus according to a sixth embodiment of the present invention;
FIG.10 is a diagram showing the construction of a plasma processing apparatus according to a seventh embodiment of the present invention; and
FIG.11 is a diagram showing the construction of a plasma processing apparatus according to an eighth embodiment of the present invention.

### BEST MODE FOR IMPLEMENTINGI THE INVENTION

Hereinafter, the present invention will be described in detail with reference to the drawings.

### [FIRST EMBODIMENT]

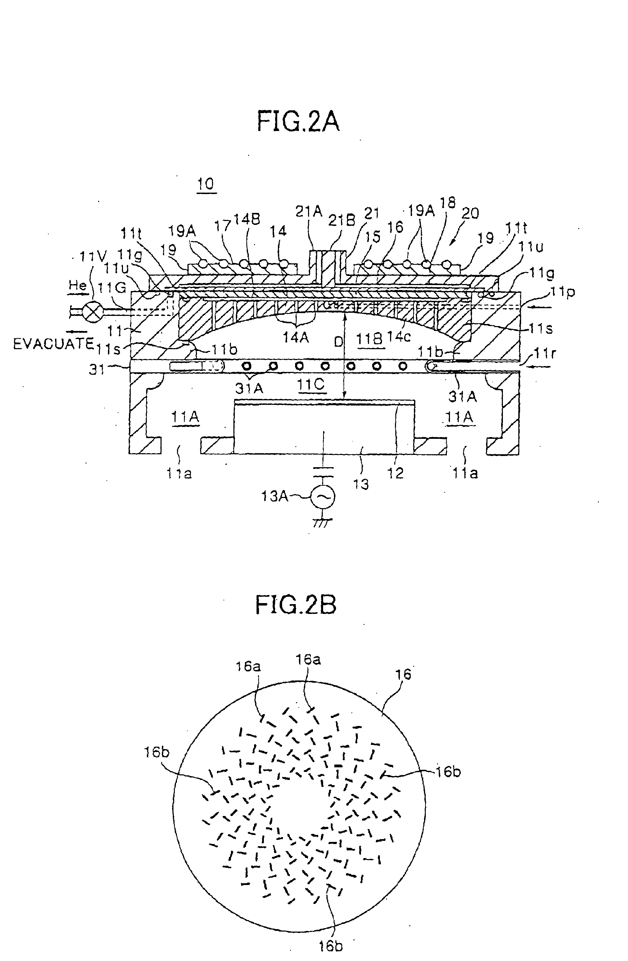

FIGS.2A and 2B show the construction of a microwave plasma processing apparatus 10 according to a first embodiment of the present invention.

Referring to FIG.2A, the microwave plasma professing apparatus 10 includes a processing vessel 11 and a stage 13 provided in the processing vessel for holding a substrate 12 to be processed by way of an electrostatic chuck, wherein the stage 13 may preferably be made of AlN or Al₂O₃ formed by a hot isotropic pressurizing (HIP) method. In the processing vessel 11, there are provided at least two, preferably three evacuation ports 11a in a space 11A surrounding the stage 13 with an equidistance relationship, and thus, in axial symmetry with respect to the substrate 12 to be processed on the stage 13. The processing vessel 11 is evacuated and depressurized via such evacuation ports 11a by means of a gradational lead screw pump, and the like.

The processing vessel 11 is preferably formed of an austenite stainless steel containing Al, and there is formed a passivation film of aluminum oxide formed on the inner wall surface of the processing vessel by an oxidizing processing. Further, in the part of the wall of the processing vessel 11 corresponding to the substrate 12 to be processed, there is formed a disk-shaped shower plate 14 of dense Al₂O₃, as a part of the wall, wherein the disk-shaped shower plate 14 may be formed by a HIP method and includes a number of nozzle apertures 14A. The Al₂O₃ shower plate 14 thus formed by a HIP process is formed by using Y₂O₃ as a sintering aid and is characterized by the porosity of 0.03% or less. This means that the Al₂O₃ shower plate 14 is substantially free from pores or pinholes. Further, the Al₂O₃ shower plate 14 has a thermal conductivity reaching the value of 30w/mK. It should be noted that this thermal conductivity value is a very large value for a ceramic.

The shower plate 14 is seated on the processing vessel 11 via a seal ring 11s, and a cover plate 15 of dense Al₂O₃ formed by a similar HIP process is mounted on the shower plate 14 via a seal ring 11t. The shower plate 14 is formed with a depression 14B at the side contacting with the cover plate 15 in communication with each of the nozzle apertures 14A, wherein the depression 14B thus formed functions as a plasma gas passage. It should be noted that the foregoing depression is formed inside the shower plate 14 in communication with another plasma gas passage that communicates with a plasma gas inlet 11p provided on the wall of the processing vessel 11.

The shower plate 14 is held by a projecting part 11b formed on the inner wall of the processing vessel 11, wherein there is formed a rounded surface on the part of the projecting part 11b carrying the shower plate 14 for suppressing abnormal electric discharge.

Thus, the plasma gas of Ar, Kr, and the like, supplied to the plasma gas inlet 11p travels through the flow paths 14C and 14B inside the shower plate 14 and is supplied to the space 11B right underneath the shower plate 14 via the apertures 14A.

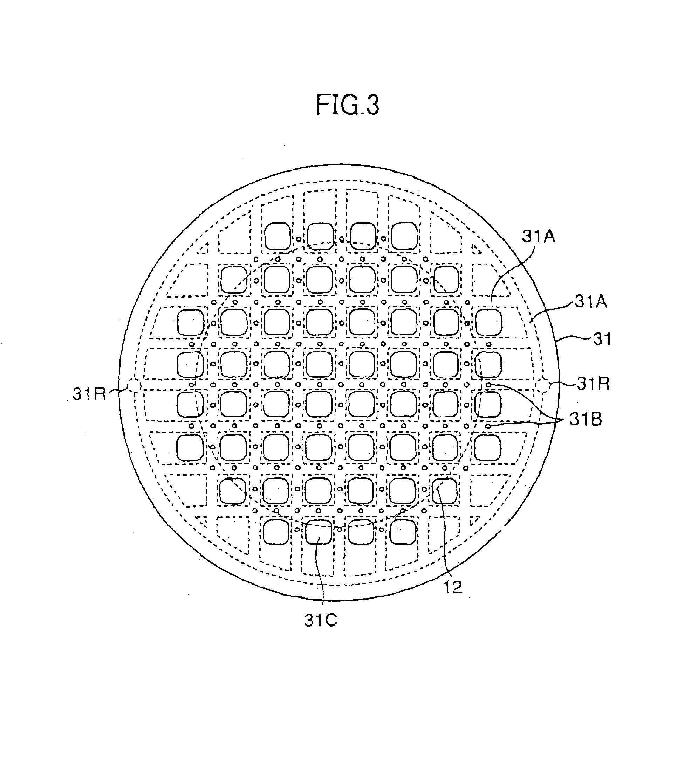

On the cover plate 15, there is provided a radial line slot antenna 20, wherein the radial line slot antenna 20 is formed of: a disk-shaped slot plate 16 provided in intimate contact with the cover plate 15 and formed with a number of slots 16a and 16b shown in FIG.3B; a disk-shaped antenna body 17 holding the slot plate 16; and a retardation plate 18 of a low loss dielectric material such as Al₂O₃, Si₃,N₄, SiON. SiO₂, and the like, interposed between the slot plate 16 and the antenna body 17. The radial line slot antenna 20 is mounted on the processing vessel 11 via a seal ring 11u, and a microwave of 2.45GHz or 8.3GHz in frequency is supplied to the radial line slot antenna 20 from an external microwave source (not shown) via a coaxial waveguide 21 having a rectangular or circular cross section. The microwave thus supplied is radiated into the processing vessel 11 from the slots 16a or 16b on the slot plate 16 through the cover plate 15 and the shower plate 14 and causes excitation of plasma in the plasma gas supplied from the foregoing apertures 14A in the space 11B right underneath the shower plate 14. Thereby, it should be noted that the cover plate 15 and the shower plate 14, formed of Al₂O₃, functions as an efficient microwave transmission window. In order to avoid excitation of plasma in the plasma gas passages 14A - 14C, the plasma gas pressure is set to about 6666Pa - 13332Pa (about 50 - 100 Torr) in the flow passages 14A -.14C.

In order to improve the intimacy of the radial line slot antenna 20 and the cover plate 15, there is formed a ring-shaped groove 11g in the microwave plasma processing apparatus 10 of the present invention in a part of the upper surface of the processing vessel 11 that engages with the slot plate 16. By evacuating the groove 11g thus formed, the gap formed between the slot plate 16 and the cover plate 15 is depressurized and the radial line slot antenna 20 is urged tightly to the cover plate 15 by the atmospheric pressure. It should be noted that such a gap is formed by the slots 16a and 16b formed in the slot plate 16, while the gap may be also formed by various minute depressions and projections. Such a gap is sealed by the seal ring 11u between the radial line slot antenna 20 and the processing vessel 11.

By filling an inert gas of small molecular weight between the slot plate 16 and the cover plate 15 from the evacuation port 11G and the groove 15g, it is possible to facilitate transportation of heat from the cover plate 15 to the slot plate 16. For such an inert gas, it is preferable to use He having a large thermal conductivity and also a large ionization potential. In the case of filling the gap with He, it is preferably to use the pressure of about 0.8 atmosphere. In the construction of FIG.3, there is provided a valve 11V in the evacuation port 11G for the evacuation of the groove 15g and for the filling of the groove 15g with the inert gas.

Further, an outer waveguide tube 21A constituting a coaxial waveguide 21A is connected to the disk-shaped antenna body 17, and the central conductor 21B is connected to the slot plate 16 through an opening formed in the retardation plate 18. Thus, the microwave supplied to the coaxial waveguide. 21A travels between the antenna body 17 and the slot plate 16 in the radial direction and is emitted from the slots 16a and 16b.

FIG.2B shows the slots 16a and 16b formed in the slot plate 16.

Referring to FIG.2B, it should be noted that the slots 16a are formed concentrically, and the slots 16b, each having an orientation perpendicular to the orientation of a corresponding slot 16a, are formed also concentrically. The slots 16a and 16b are formed with an interval corresponding to the wavelength of the microwave compressed by the retardation plate 18 in the radial direction of the slot plate 16, and as a result, the microwave is emitted from the slot plate generally in the form of a plane wave. Because the slots 16a and 16b are formed in the mutually perpendicular orientations, the microwave thus emitted constitutes a circular polarization wave containing two perpendicular polarization components.

In the plasma processing apparatus 10 of the present embodiment, it should be noted that the shower plate 14 has a concaved surface at the side. facing the substrate 12 to be processed. As a result, the separation D between the shower plate 14 and a plane set coincident to the surface of the substrate 12 to be processed decreases gradually in the radially outward direction. Thus, the concaved surface is defined by an axially symmetric surface and the separation D is decreased at the peripheral part of the substrate 12 to be processed. Thereby, the problem of decrease of plasma density in the peripheral part of the substrate is eliminated.

Thus, in the plasma processing apparatus 10 noted above, the plasma density is not decreased below the cutoff density even in the case plasma processing is conducted under a reduced pressure environment as in the case of conducting a dry etching process, and the plasma is maintained stably. Thereby, the problem of vanishing of the plasma and associated problem of damaging of the substrate taking place at the peripheral part of the substrate is successfully avoided.

Further, in the plasma processing apparatus 10 of FIG.2A, it should be noted that there is provided a cooling block 19 having a cooling water passage 19A on the antenna body 17. Thus, by cooing the cooling block 19 by the cooling water in the cooling water passage 19A, the heat accumulated in the shower plate 14 is successfully absorbed via the radial line slot antenna 20. It should be noted that the cooling water passage 19A has a spiral form and is preferably supplied with the cooling water having an adjusted oxidation-reduction potential. Such cooling water having adjusted oxidation-reduction potential may be obtained by conducting a bubbling of an H₂ gas for expelling the dissolved oxygen.

In the microwave plasma processing apparatus 10 of FIG.2A, it should be noted that there is provided a process gas supplying structure 31 in the processing vessel between the shower plate 14 and the substrate 12 on the stage 13, wherein the process gas supplying structure 31 includes lattice-formed process gas passages 31A releasing a process gas supplied from a process gas inlet 11r provided on the wall of the processing vessel 11, wherein the process gas is released from a number of process gas nozzle apertures 31B (see FIG.3). Thereby, a uniform substrate processing is conducted in the space 11C between the process gas supplying structure 31 and the substrate 12. It should be noted that such a substrate processing includes processes such as plasma oxidation, plasma nitridation, plasma oxynitridation, and plasma CVD. Further, it is possible to conduct a reactive ion etching to the substrate 12 to be processed by supplying a fluorocarbon gas easily causing dissociation such as C₄F₉, C₅F₈, C₄F₆, and the like, or an etching gas of fluoride or chloride into the space 11C from the process gas supplying structure 31, and simultaneously applying a high frequency voltage to the stage 13 from a high-frequency source 13A.

In the microwave plasma processing apparatus 10 of the present embodiment, it is possible to avoid deposition of reaction byproducts on the inner wall of the processing vessel by heating the wall of the processing vessel 11 to a temperature of about 150°C. Thus, it becomes possible to operate the microwave plasma processing apparatus 10 constantly with stability, by conducting a dry cleaning process with a rate of once per day.

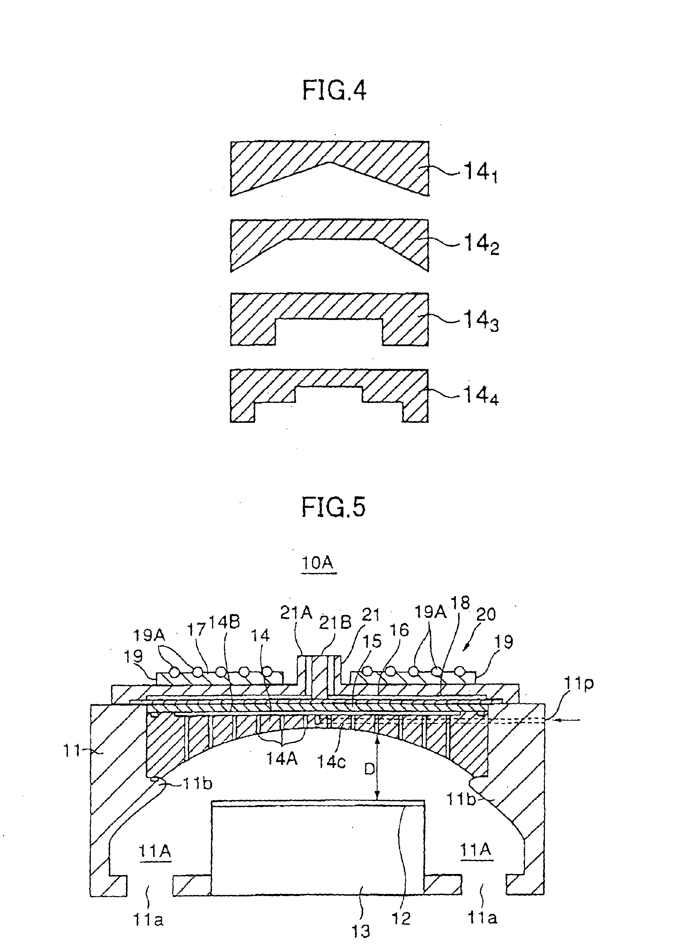

FIG.4 is a bottom view showing the construction of the process gas supplying structure 31 used in the construction of FIG.2A.

Referring to FIG.4, the process gas supplying structure 31 is formed of a conductive material of an Al alloy containing Mg or a stainless steel added with Al, and the lattice-shaped gas passage 31A is connected to the process gas inlet port 11r at a process gas supplying port 31R. Thereby, the process gas is released into the foregoing space 11C uniformly from the process gas nozzle apertures 31B formed with a large number at the bottom surface of the process gas supplying structure 31. Further, the process gas supplying structure 31 is formed with openings 31C between adjacent process gas passages 31A so as to allow passage of the plasma or the process gas contained in the plasma. In the case of forming the process gas supplying structure 31 by an Al alloy containing Mg, it is preferable to form a fluoride film on the surface thereof. Further, in the case of forming the process gas supplying structure 31 by a stainless steel added with Al, it is preferable to form a passivation film of aluminum oxide on the surface thereof. In the plasma processing apparatus 10 of the present invention, it should be noted that the incident energy of plasma is small because of the low electron temperature of the excited plasma, and there occurs no problem of contamination in the substrate 12 by the sputtering of the process gas supplying structure 31. Further, it is possible to form the process gas supplying structure 31 by a ceramic such as alumina.

It should be noted that the lattice-shaped process gas passages 31A and the process gas nozzle apertures 31B are formed so as to cover a region slightly larger than the substrate 12 to be processed as represented in FIG.4. By providing such a process gas supplying structure 31 between the shower plate 14 and the substrate 12 to be processed, it becomes possible to cause plasma excitation of the process gas such as a source gas or an etching gas and conduct a processing of the substrate uniformly by using the plasma-excited process gas.

In the case of forming the process gas supplying structure 31 by a conductor such as a metal, the process gas supplying structure 31 can form a ground plane with regard to the microwave by setting the separation between the lattice-shaped process gas passages 31A to be smaller than the wavelength of the microwave. In this case, the microwave excitation of plasma takes place only in the space 11B, and the activation of the process gas is caused in the space 11C, including the surface of the substrate 12 to be processed, by the plasma diffused from the excitation space 11B.

In the microwave plasma processing apparatus 10 of the present embodiment, the supply of the process gas is controlled uniformly by using the process gas supplying structure 31. Thus, the problem of excessive dissociation of the process gas at the surface of the substrate 12 is eliminated and it becomes possible to conduct the desired substrate processing even in such a case a structure of high aspect ratio is formed on the substrate surface, such that the substrate processing reaches up to the inner part of the high-aspect structure. Thus, the microwave plasma apparatus 10 is useful for fabrication of semiconductor devices of different generations and different design rules.

In the plasma processing apparatus 10B of FIG.5, it becomes possible to deposit various high-quality films uniformly at low temperature or conduct an etching process also uniformly on the entire surface of the substrate 12, by introducing various oxidation gases or nitriding gases, source gases or etching gases from the foregoing process gas supplying structure 13.

FIG.4 shows the construction of shower plates 14₁ - 14₄ according to various modifications of the shower plate 14.

Referring to FIG.4, it can be seen that the shower plate 14₁ has a conical concaved surface at the side facing the substrate 12, while in the case of the shower plate 14₂, the concaved surface has a truncated conical shape. Further, in the case of the shower plate 14₃, the concaved surface is formed by a circular depression forming a stepped structure. In the case of the shower plate 14₄, the concaved surface is formed of plural depressions forming plural steps. These depressions are formed in axial symmetry with respect to a central axis of the shower plate and a uniform processing is guaranteed about the foregoing central axis.

### [SECOND EMBODIMENT]

FIG.5 shows the construction of a plasma processing apparatus 10A according to a second embodiment of the present invention. In FIG.5, those parts corresponding to the parts described previously are designated by the same reference numerals and the description thereof will be omitted.

Referring to FIG.5, the plasma processing apparatus 10A has a construction similar to that of the plasma processing apparatus 10 and has the feature that the separation D between the substrate 12 and the shower plate 14 decreases in the radially outward direction of the shower plate 14, wherein it should be noted that the process gas supplying part is eliminated in the plasma processing apparatus 10A.

In the plasma processing apparatus 10B of such a construction, it is not possible to conduct a film formation or etching process by supping a process gas separately to the plasma gas because of the elimination of the lower shower plate 31. On the other hand, it is possible to form an oxide film or a nitride film, or an oxynitride film on the surface of the substrate by supplying an oxidizing gas or a nitriding gas from the shower plate 14 together with the plasma gas. In the plasma processing apparatus 10A of the present embodiment, the construction is. simplified and the manufacturing cost is reduced significantly.

In the present embodiment, too, the drop of plasma density in the peripheral part of the substrate 12 is compensated for by the decrease of the separation D at the peripheral part of the substrate 12 to be processed. Thereby, the plasma is maintained stably, and the problem such as vanishing of plasma in the peripheral part of the substrate 12 and associated problem of damaging of the substrate, or decrease of the processing speed is successfully avoided.

In the plasma processing apparatus 10A of FIG.5, it is possible to conduct the oxidizing processing, nitriding processing, oxynitriding processing, and the like, uniformly and efficiently even at low temperatures with low cost, even in the case the substrate is a large-diameter substrate.

In the present embodiment, too, it is possible to use any of the shower plates 14₁ - 14₄ explained with reference to FIG. 4 in place of the shower plate 14.

### [THIRD EMBODIMENT]

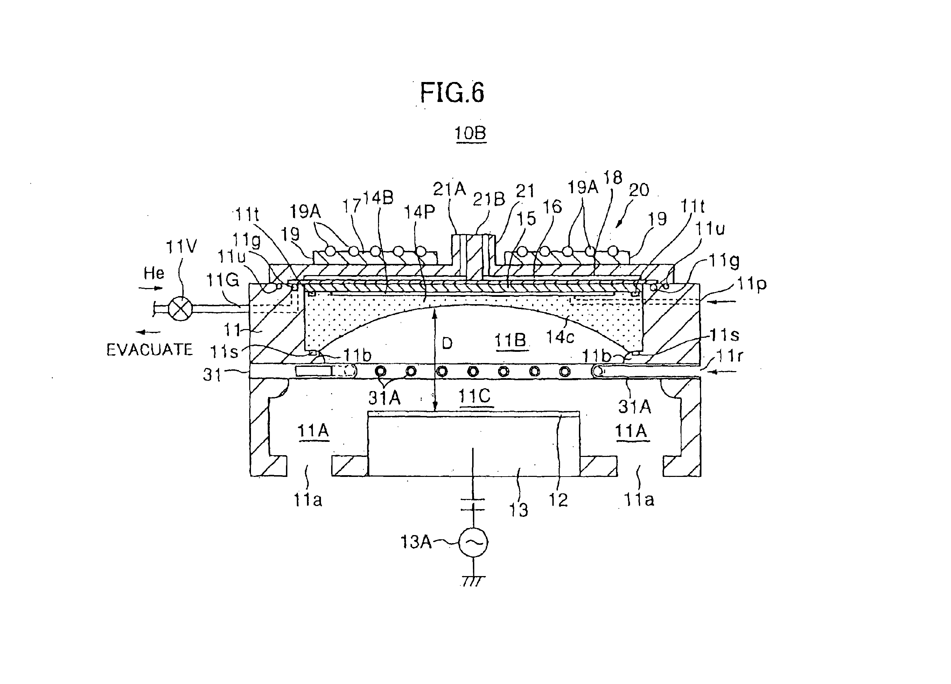

FIG.6 shows the construction of a plasma processing apparatus 10B according to a third embodiment of the present invention, wherein those parts of FIG.6 corresponding to the parts explained before are designated by the same reference numerals and the description thereof will be omitted.

Referring to FIG.6, the present embodiment uses a shower plate 14P of a porous ceramic such as sintered alumina in place of the shower plate 14.

In the shower plate 14P, it should be noted that there is formed no shower apertures 14A as in the case of the shower plate 14. On the other hand, the shower plate 14P is also formed with the plasma gas supply paths 14C and 14B connected to the plasma gas supplying port 11P, and the plasma gas thus supplied is released into the foregoing space 11B from the plasma gas supply path 14B uniformly through the pores formed in the porous shower plate 14P.

In the present embodiment, too, the lower surface of the shower plate 14P forms an axially symmetric concaved surface and the separation D between the foregoing lower surface and the surface of the substrate 12 decreases toward the peripheral part of the substrate 12. Because of this, the drop of plasma density at the peripheral part of the substrate 12 is compensated for in the construction of FIG.6 and it becomes possible to maintain the plasma stably. Thereby, the problems such as vanishing of plasma in the peripheral part of the substrate 12 and associated problem of damaging of the substrate by the microwave or decrease of the processing speed are successfully avoided.

In the plasma processing apparatus 10B of FIG.6, it becomes possible to deposit various high-quality films uniformly at low temperature or conduct an etching process also uniformly on the entire surface of the substrate 12, by introducing various oxidation gases or nitriding gases, source gases or etching gases. Alternatively, it is possible to conduct an etching process on the surface uniformly.

In the present embodiment, too, it is possible to use various concaved surfaces shown in FIG.4 for the concaved surface of the porous shower plate 14P.

### [FOURTH EMBODIMENT]

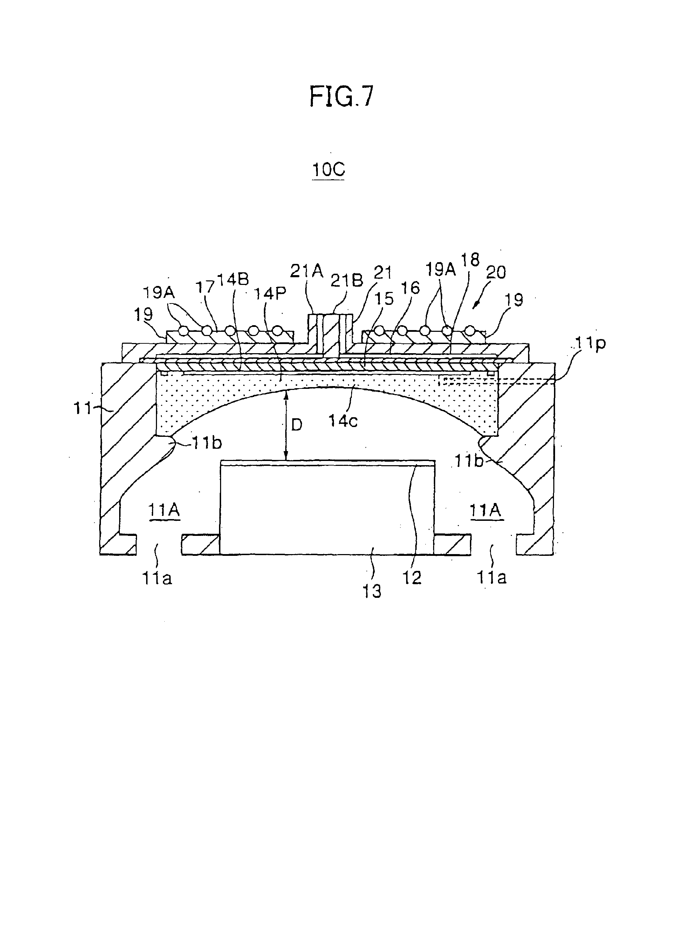

FIG.7 shows the construction of a plasma processing apparatus 10C according to a fourth embodiment of the present invention, wherein those parts of FIG.7 corresponding to the parts explained before are designated by the same reference numerals and the description thereof will be omitted.

Referring to FIG.7, the plasma processing apparatus 10C of the present embodiment has a construction similar to that of the plasma processing apparatus 10B described previously, except that the lower shower plate 31 is removed. Further, projecting part 11b holding the shower plate 14 has a rounded surface on the entirety thereof.

In the plasma processing apparatus 10C of such a construction in which the lower shower plate 31 is omitted, it is not possible to conduct film formation process or etching process by supplying a process gas separately to the plasma gas. Nevertheless, it is possible to form an oxide film, a nitride film or an oxynitride film on the surface of the substrate to be processed by supplying an oxidizing gas or nitriding gas from the shower plate 14 together with the plasma gas.

In the present embodiment, too, the lower surface of the shower plate 14P forms an axially symmetric concaved surface and the separation D between the foregoing lower surface and the surface of the substrate 12 decreases toward the peripheral part of the substrate 12. Because of this, the drop of plasma density at the peripheral part of the substrate 12 is compensated for in the construction of FIG.6 and it becomes possible to maintain the plasma stably. Thereby, the problems such as vanishing of plasma in the peripheral part of the substrate 12 and associated problem of damaging of the substrate by the microwave or decrease of the processing speed are successfully avoided.

In the plasma processing apparatus 10C of FIG.7, it becomes possible to conduct the processes of the substrate 12 such as oxidation processing, nitridation processing, oxynitridation processing, and the like, efficiently and uniformly at low temperature with low cost even in the case the substrate is a large-diameter substrate.

In the present embodiment, too, it is possible to use various concaved surfaces shown in FIG.4 for the concaved surface of the porous shower plate 14P.

### [FIFTH EMBODIMENT]

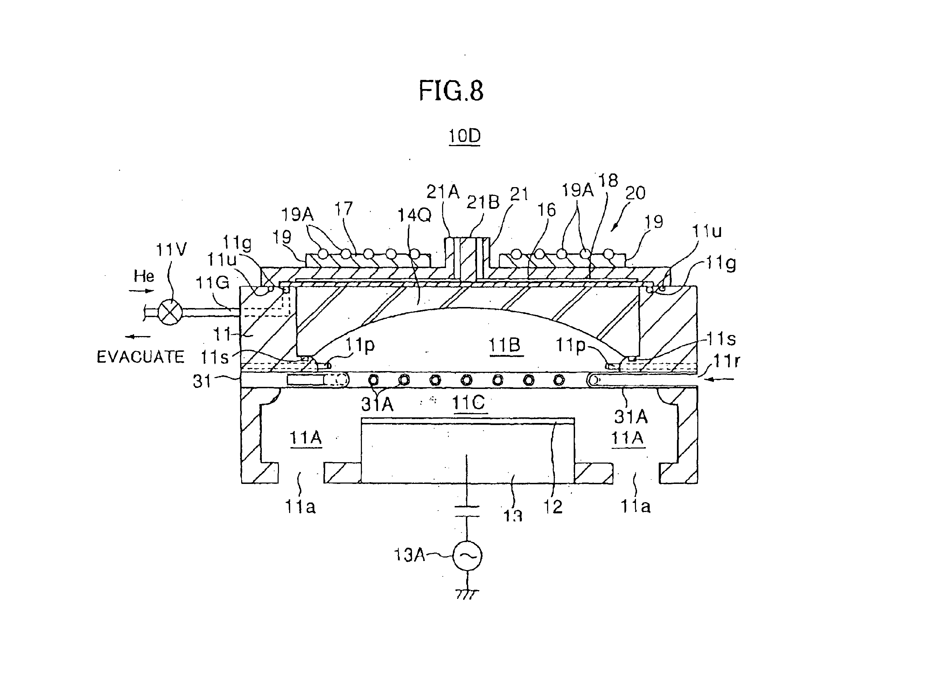

FIG.8 shows the construction of a plasma processing apparatus 10D according to a fifth embodiment of the present invention, wherein those parts of FIG.8 corresponding to the parts explained before are designated by the same reference numerals and the description thereof will be omitted.

Referring to FIG.8, the porous shower plate 14P and the cover plate 15 of the embodiment of FIG.6 are removed in the present embodiment, and in place thereof, there is provided a microwave transmission window 14Q of a dense ceramic, wherein the microwave transmission window 14Q has a concaved surface at the side facing the substrate 12. The microwave transmission window 14 may be formed of a material of small dielectric loss, such as alumina formed by a HIP process.

In the construction of FIG.8, it should be noted that the microwave transmission window 14Q functions also as the cover plate 15. On the other hand, the cover plate 15 is not formed with the plasma gas flow path 14C or apertures 14A communicating with the foregoing flow path 14C, and in stead thereof, there is provided a plasma gas inlet part at the wall of the processing vessel 11 in the form of a tube 11P. Further, a radial line slot antenna 20 is provided on the microwave transmission window 14Q in intimate contact therewith. It is preferable that the foregoing tube 11P is formed with plural number in symmetry around the substrate 12 to be processed.

In such a construction; the lower surface of the microwave transmission window 14Q forms an axially symmetric concaved surface and the separation D between the foregoing lower surface and the surface of the substrate 12 decreases toward the peripheral part of the substrate 12. Because of this, the drop of plasma density at the peripheral part of the substrate 12 is compensated for in the construction of FIG.8 and it becomes possible to maintain the plasma stably. Thereby, the problems such as vanishing of plasma in the peripheral part of the substrate 12 and associated problem of damaging of the substrate by the microwave or decrease of the processing speed are successfully avoided.

In the plasma processing apparatus 10D of FIG.8, it becomes possible to conduct the processes of the substrate 12 such as oxidation processing, nitridation processing, oxynitridation processing, and the like, efficiently and uniformly at low temperature with low cost even in the case the substrate is a large-diameter substrate.

In the present embodiment, too, it is possible to use various concaved surfaces shown in FIG.4 for the concaved surface of the plasma transmission window.

### [SIXTH EMBODIMENT]

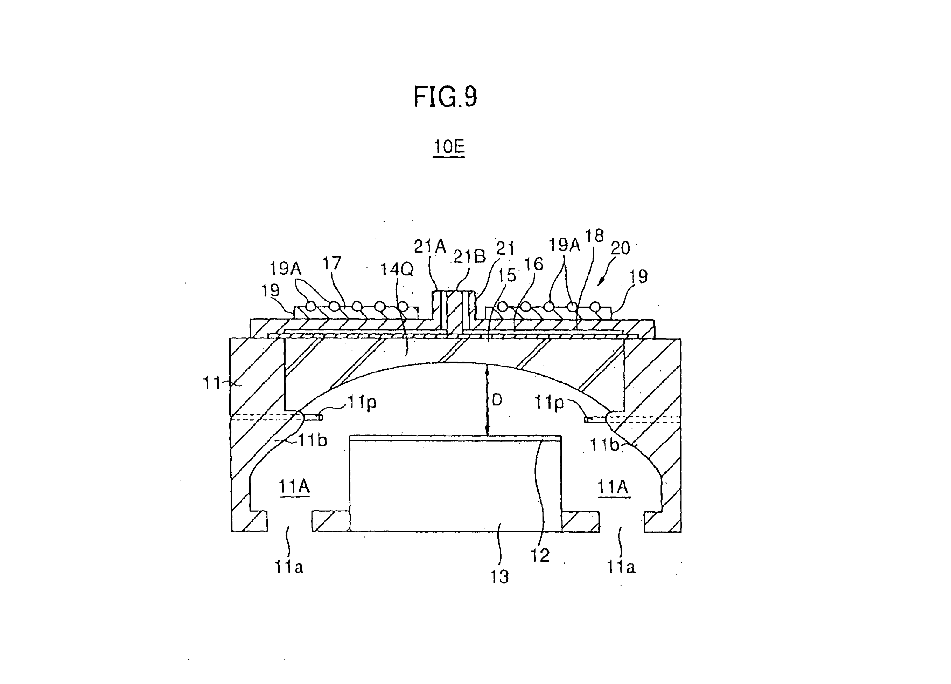

FIG.9 shows the construction of a plasma processing apparatus 10E according to a sixth embodiment of the present invention, wherein those parts described previously are designated by the same reference numerals and the description thereof will be omitted.

Referring to FIG.9, the plasma processing apparatus 10E of the present embodiment has a construction similar to the plasma processing apparatus 10D described above, except that the process gas supplying structure 31 is eliminated.

In such a structure, it becomes possible to form a high-quality film of oxide, nitride or oxynitride uniformly at low temperature on the surface of the substrate 12 by introducing an oxidizing gas such as O₂ or a nitriding gas such as NH3 or a mixed gas of N₂ and H₂, together with an inert gas such as Kr or Ar, from the plasma gas inlet tube 11P.

Because the separation D between the lower surface of the microwave transmission window 14A and the substrate 12 to be processed is decreased at the peripheral part of the substrate 12 to be processed, a sufficient plasma density is secured at the peripheral part of the substrate 12 and the processing of the substrate 12 is conducted uniformly.

In the microwave window 14Q of the present embodiment, too, it is possible to use various concaved surfaces shown in FIG.4.

### [SEVENTH EMBODIMENT]

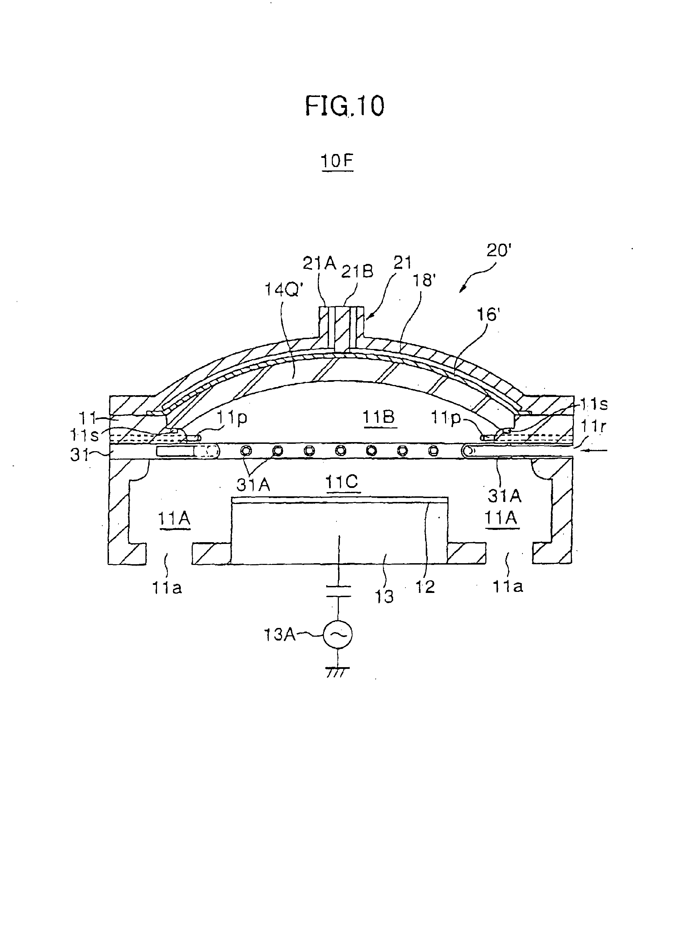

FIG.10 shows the construction of a plasma processing apparatus 10F according to a seventh embodiment of the present invention, wherein those parts described previously are designated by the same reference numerals and the description thereof will be omitted.

Referring to FIG.10, it should be noted that the present embodiment uses a dielectric window 14Q' having a uniform thickness in place of the foregoing dielectric window 14Q.

In such a dielectric window 14Q', there is formed a convex surface at the top part in correspondence to the concaved surface formed at the bottom part of the dielectric window 14Q'. Thus, in the plasma processing apparatus 10 of FIG.10, a radial line slot antenna 20' having a concaved surface corresponding to the foregoing convex surface, is used in place of the radial line slot antenna 20 having a flat surface. Thus, the radial line slot antenna 20' has a slot plate 16' having a concaved surface, and an antenna body 17' having a concaved surface is mounted on the foregoing slot plate 16' via an intervening curved retardation plate 18'.

In the plasma processing apparatus 10F of such a construction, too, the drop of plasma density at the peripheral part of the substrate 12 is successfully compensated for. Further, by supplying various process gases from the process gas supplying part 31, it becomes possible to conduct various plasma processes, including oxidation, nitridation, oxynitridation, deposition of various layers, etching, and the like, over the entire surface of the substrate 12 uniformly and stably.

### [EIGHTH EMBODIMENT]

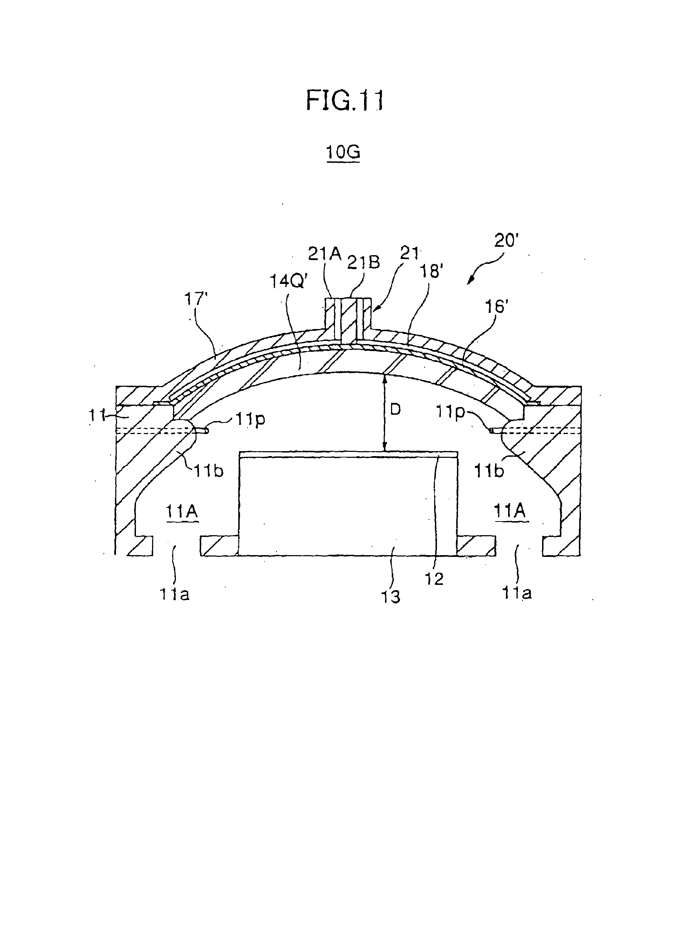

FIG.11 shows the construction of a plasma processing apparatus 10G according to an eighth embodiment of the present invention, wherein those parts corresponding to the parts described previously are designated by the same reference numerals and the description thereof will be omitted.

Referring to FIG.11, the plasma processing apparatus 10G has a construction similar to the plasma processing apparatus 10F of the previous embodiment, except that the process gas supplying part 31 is eliminated.

In the substrate processing apparatus 10G of the present embodiment, too, the drop of plasma density in the peripheral part of the substrate 12 can be compensated and it becomes possible to conduct a plasma process such as oxidation, nitridation or oxynitridation over the entire surface of the substrate uniformly.

Further, the present invention is not limited to the foregoing specific embodiment but various variations and modifications may be made without departing from the scope of the invention described in claims.

### INDUSTRIAL APPLICABILITY

According to the present invention, the drop of plasma density in the peripheral part of the substrate is compensated for and plasma is maintained stably even in a low-pressure process. Thereby, stable plasma processing is realized.

## Claims

1. A plasma processing apparatus, **characterized by**:
a processing vessel defined by a wall and provided with.a stage for holding a substrate to be processed;
a microwave transmission window provided on said processing vessel so as to face said substrate' to be processed on said stage, said microwave transmission window being provided as a part of said wall of said processing vessel;
a plasma gas supplying part supplying a plasma gas into said processing vessel; and
a microwave antenna provided on said processing vessel in correspondence to said microwave,
said microwave transmission window having a concaved inner surface at a side facing said substrate to be processed, such that a separation between said inner surface and a plane coincident to a surface of said substrate to be processed decreases in a radially outward direction of said microwave transmission window.

2. The plasma processing apparatus as claimed in claim 1, **characterized in that** said separation decreases continuously in a radially outward direction of said microwave transmission window.

3. The plasma processing apparatus as claimed in claim 2, **characterized in that** said separation decreases smoothly in said radially outward direction of said microwave transmission window.

4. The plasma processing apparatus as claimed in claim 2, **characterized in that** said separation decreases linearly in said radially outward direction of said microwave transmission window.

5. The plasma processing apparatus as claimed in claim 2, **characterized in that** said separation decreases in a non-linear relationship in said radially outward direction of said microwave transmission window.

6. The plasma processing apparatus as claimed in claim 1, **characterized in that** said separation decreases stepwise in said radially outward direction of said microwave transmission window.

7. The plasma processing apparatus as claimed in claim 1, **characterized in that** said separation is decreased in said radially outward direction of said microwave transmission widow exclusively in a peripheral part of said microwave transmission window.

8. The plasma processing apparatus as claimed in claim 1, **characterized in that** said microwave transmission window has a flat surface at an outer surface thereof opposing.said inner surface.

9. The plasma processing apparatus as claimed in claim 1, **characterized in that** said microwave transmission window includes a plasma gas passage therein, said microwave transmission window constituting said plasma gas supplying part and releasing said plasma gas into said processing vessel.

10. The plasma processing apparatus as claimed in claim 9, **characterized in that** said microwave window includes a plurality of apertures communicating with said plasma gas passage.

11. The plasma processing apparatus as claimed in claim 10, **characterized in that** said microwave transmission window comprises a cover plate forming a part of said wall of said processing vessel, and a shower plate provided in intimate contact with said cover plate and having a plurality of apertures communicating with said plasma gas passage.

12. The. plasma processing apparatus as claimed in claim 10, **characterized in that** said microwave transmission window comprises a dense ceramic.

13. The plasma processing apparatus as claimed in claim 9, **characterized in that** said microwave plasma processing window is formed of a porous medium.

14. The plasma processing apparatus as claimed in claim 9, **characterized in that** said microwave transmission window comprises a cover plate constituting a part of said processing vessel and a shower plate of a porous medium provided in intimate contact with said cover plate.

15. The plasma processing apparatus as claimed in claim 13, **characterized in that** said porous medium is formed of a sintered ceramic.

16. The plasma processing apparatus as claimed in claim 1, **characterized in that** said plasma gas supplying part comprises a tube formed in said wall of said processing vessel so as to be connectable to a plasma gas source.

17. The plasma processing apparatus as claimed in claim 16, **characterized in that** said microwave transmission window comprises a dense ceramic.

18. The plasma processing apparatus as claimed in claim 1, further **characterized by** a process gas supplying part between said substrate to be processed and said plasma gas source.

19. The plasma processing apparatus as claimed in claim 18, **characterized in that** said process gas supplying part comprises a plasma passage causing to pas plasma, a process gas supplying passage connectable to a process gas source; and a large number of nozzle apertures communicating with said process gas passage.

20. The plasma processing apparatus as claimed in claim 1, further **characterized by** a high-frequency source connected to said stage.

21. The plasma processing apparatus as claimed in claim 1, **characterized in that** said microwave antenna comprises a radial line slot antenna.
